# EUROPEAN PATENT SPECIFICATION

(11) **EP 2 867 926 B1**
(45) Date of publication and mention of the grant of the patent: **05.04.2017**
(21) Application number: 12730973.0
(22) Date of filing: 29.06.2012
(51) Int. Cl.: H01L 31/0747

(54) **SOLAR CELL**
SOLARZELLE
CELLULE SOLAIRE

(43) Date of publication of application: 06.05.2015
(73) Proprietor: Ecole Polytechnique Fédérale de Lausanne (EPFL), 1015 Lausanne (CH)
(72) Inventor: BALLIF, Christophe, CH-2000 Neuchâtel (CH); GEISSBÜHLER, Jonas, CH-2000 Neuchâtel (CH)
(74) Representative: Gevers SA
(86) International application number: PCT/EP2012/062776
(87) International publication number: WO 2014/000826

(56) References cited:
- LULU ZHANG ET AL: "Impact of back surface patterning process on FF in IBC-SHJ", PHOTOVOLTAIC SPECIALISTS CONFERENCE (PVSC), 2012 38TH IEEE, IEEE, 3 June 2012 (2012-06-03), pages 1177-1181, XP032258029, DOI: 10.1109/PVSC.2012.6317811 ISBN: 978-1-4673-0064-3
- LU MEIJUN ET AL: "Interdigitated back contact silicon heterojunction solar cell and the effect of front surface passivation", APPLIED PHYSICS LETTERS, AIP, AMERICAN INSTITUTE OF PHYSICS, MELVILLE, NY, US, vol. 91, no. 6, 8 August 2007 (2007-08-08) , pages 63507-63507, XP012100564, ISSN: 0003-6951, DOI: 10.1063/1.2768635
- DESRUES T ET AL: "SLASH concept: A novel approach for simplified interdigitated back contact solar cells fabrication", PHOTOVOLTAIC SPECIALISTS CONFERENCE (PVSC), 2012 38TH IEEE, IEEE, 3 June 2012 (2012-06-03), pages 1602-1605, XP032258119, DOI: 10.1109/PVSC.2012.6317901 ISBN: 978-1-4673-0064-3

## Description

### Technical Field

The present invention relates to the field of solar cells, and particularly of high efficiency crystalline silicon solar cells. More particularly, the present invention relates to a solar cell comprising a semiconductor wafer, an emitter formed by at least one emitter region which comprises at least a first layer of a first conductivity type and a first contact layer allowing a carrier extraction or injection, a backcontact comprising at least a second layer of a second conductivity type opposite of said first conductivity type and a second contact layer allowing a carrier extraction or injection, electrical contacts which are connected to said emitter regions and said backcontact respectively and designed to transport an electrical current out of the solar cell.

A particularly advantageous application of the present invention is for the production of photovoltaic cells intended for generating electrical energy, but the invention also applies, more generally, to any structure in which light radiation is converted into an electrical signal, such as photodetectors.

### Background of the invention

A classical photovoltaic solar cell comprises typically on its front side a metal grid pattern. The contact fingers are made out of a metal. The busbars are usually contacted (soldered, welded or attached with a conductive glue or adhesive) with a highly conductive metal band to extract the current that is generated homogeneously over the optically active area (i.e. not covered by the contact grid) and collected by the thin fingers or grid contact.

When metal contacts touch directly a semiconductor, the excess minority carriers (which should be collected by the junction) in the semiconductor tend to recombine at this contact. Hence classical solar cells need to minimize the contact area between the metal and the semiconductor. In advanced solar cells, if such a contact is present, a higher doping is attempted below the contact to "screen" the metal. The rest of the cell is usually coated by a layer that allows an electronic passivation of the solar cells.

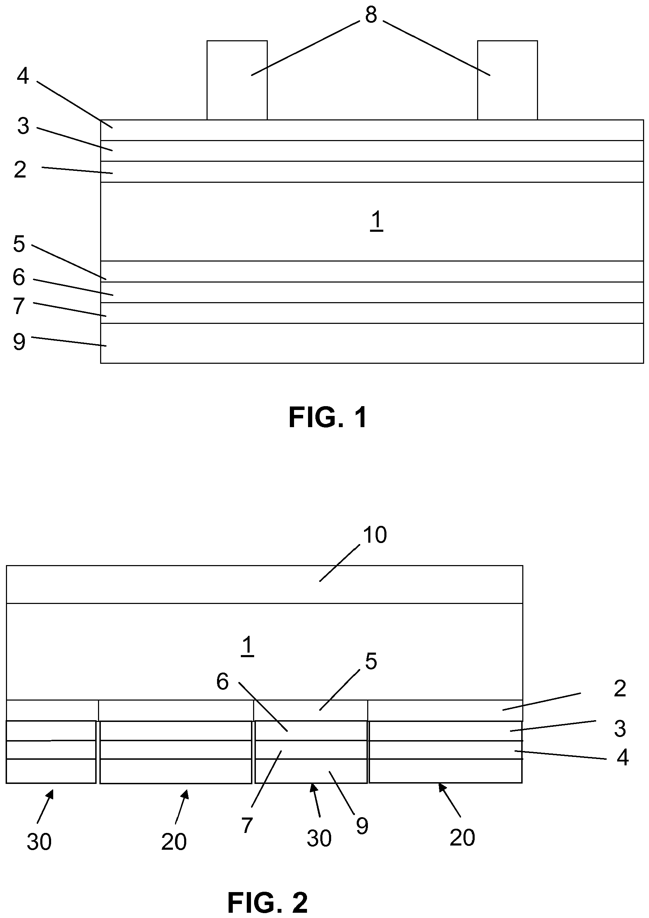

Another approach to make better electrical contacts is the use of layer stacks that allow at the same time a current extraction (current created by collecting the photogenerated carriers) and a passivation of contact. This is the case with the so called amorphous silicon/crystalline silicon heterojunction concept. As shown by Figure 1, such a cell is usually formed the following way: a typically n-type crystalline silicon wafer 1 is electronically passivated with an intrinsic layer 2 and 5 of hydrogenated amorphous silicon on both sides of 5-15 nm thickness. At the front a doped p-layer 3 is present and a front transparent conductive oxide (TCO) 4 covers the front p-layer 3. In the present description, the i-p-TCO stack is called "emitter". The photogenerated carriers are collected through the emitter, i.e. under illumination a photocurrent is collected homogeneously from the illuminated area.

At the back an n-layer 6 covers the i-layer 5 and a TCO 7 covers the n-layer 6. In the present description, the i-n-TCO stack is called "backcontact". The current can flow through this contact (because the i-layer is thin), but a good electronic passivation is ensured. At the frontside of the solar cell, the electrical current is transported out of the solar cell by metallic conductors 8 (for the front side), named grid fingers, that join then busbars, whereas the backside can either have a similar pattern as the front side, or be covered by a metal layer 9 that will conduct the current to busbars at the back. The metal at the front and at the back are required because the lateral conductivity of the TCO is not high enough to allow a transport without resistive losses, as soon as the distance exceeds typically a few mm. This configuration is called Front SHJ. The TCO layer 4 acts also as an antireflection coating.

The TCO at the front side has a high conductance (a sheet resistance in the range of 20 to 200 Ohm /sq) to allow a lateral transport of the electrical current collected by the emitter to the next contact fingers. The stack i-p-TCO covers the full front of the solar cell at the exception of the edges to avoid short circuits.

A particularity of these devices is the achievement of high open-circuit voltage typically 710 to 750 mV, higher than standard diffused crystalline solar cells, in which the direct contact between the semiconductor and the TCO (or equivalently the metal), leads to lower voltage.

In another configuration as shown by Figure 2, the cell comprises a n-type wafer 1, but both the emitter (stack i-p-TCO, 2-3-4) and backcontact (stack i-n-TCO, 5-6-7), covered by a metal layer 9, are placed at the back of the solar cell, in alternance of emitter regions 20 and backcontact regions 30. This configuration with all contacts at the back is called backcontacted heterojunction cell (IBC-SHJ). In this case an efficient passivation needs to be realized at the front via a layer 10, usually combined with an antireflection effect and sometimes with some lateral conductivity to reduce resistive losses created by current flow. This configuration is for example disclosed in "Impact of back surface patterning process on FF in IBC-SHJ" from Zhang et al., Photovoltaic Specialists Conference (PVSC), 2012, 38TH, IEEE, pp 1177.

In order to collect most efficiently the photogenerated carrier in the cell, so far, all authors have maximized the coverage of the solar cell with emitter. In the Front SHJ configuration, close to 100% of the front surface is covered with the emitter, and in the IBC-SHJ configuration it is typically 50 to 70% of the backside that is covered with the emitter, whereas the rest is covered with the back-contact.

Even though the schemes described above can lead to high efficiencies (today's certified efficiencies reported of 23.7% in case of Front-SHJ and 20.2% in the case of IBC-SHJ), these solar cells work as solar cell operating under standard 1 sun illumination, not allowing one to take advantage of concentration effects that can lead to higher performance of the cells. Concentration is usually achieved using lens or mirror that increases the cells Voc and the efficiency (providing no high series resistance are present).

Another disadvantage is that the i-layer, the p and n layers, and the TCO (on both sides of the cells) lead to parasitic light absorption that cannot be used by the solar cell. This is especially the case of the Front-SHJ, in which strong absorption in the blue green part of the spectrum occurs in the i and p layers, and of the TCO which creates free carrier absorption in the red part of the spectrum. The layers lead to minor absorption in the case of the IBC-SHJ. However in this case a precise patterning at the backside is required, in order to have the TCO 4 or 7 or the TCO/metal stack 4+9 or 7+9 come as close as possible to the edge of the regions with the p and n layers, making it difficult to manufacture.

### Summary of the invention

The present invention provides a solar cell which allows to avoid the disadvantages of the prior art.

Accordingly, the present invention relates to a solar cell comprising:
- a semiconductor wafer,
- an emitter formed by at least one emitter region which comprises at least a first layer of a first conductivity type and a first contact layer allowing a carrier extraction or injection,
- a backcontact comprising at least a second layer of a second conductivity type opposite of said first conductivity type and a second contact layer allowing a carrier extraction or injection,
- electrical contacts which are connected to said emitter regions and said backcontact respectively and designed to transport an electrical current out of the solar cell.

According to the present invention, the area of the emitter covers between 0.5% to 15%, preferably between 1% and 10% and more preferably between 2% and 5% of the area of a side of the wafer on which the emitter regions are provided, the rest of the area of said side of the wafer being covered by first passivating regions which comprise at least a first passivating layer and at least one first optional additional layer which makes that the first passivating layer does not allow a carrier extraction or injection, said first passivating regions being not fully covered by the first layer of the first conductivity type of the emitter regions. Preferably, the first layer of the first conductivity type of the emitter regions may cover at most 10% of the surface of a first passivating region.

In some embodiments, the emitter is provided on a front side of the solar cell. The backcontact may be of a classical type or the backcontact may be formed by at least one backcontact region which comprises at least a second layer of the second conductivity type and a second contact layer allowing a carrier extraction or injection, the area of the backcontact covering between 0.5% to 15%, preferably between 1% and 10% and more preferably between 2% and 5% of the area of the backside of the wafer, the rest of the area of the backside of the wafer being covered by second passivating regions which comprise at least a second passivating layer and at least one second optional additional layer which makes that the second passivating layer does not allow a carrier extraction or injection, said second passivating regions being not fully covered by the second layer of the second conductivity type of the backcontact regions. Preferably, the second layer of the second conductivity type of the backcontact regions may cover at most 10% of the surface of a second passivating region.

In other embodiments not part of the invention, the emitter may be provided on a back side of the solar cell as well, the backcontact is formed by at least one backcontact region which comprises at least a second layer of the second conductivity type and a second contact layer allowing a carrier extraction or injection, and the areas of the emitter and of the backcontact cover between 0.5% to 15%, preferably between 1% and 10% and more preferably between 2% and 5% of the area of the back side of the wafer, the rest of the area of the backside of the wafer being covered by third passivating regions which comprise at least a third passivating layer and at least one third optional additional layer which makes that the third passivating layer does not allow a carrier extraction or injection, said third passivating regions being not fully covered by the first layer of the first conductivity type of the emitter regions or by the second layer of the second conductivity type of the backcontact regions, the backcontact regions being provided alternatively with the emitter regions, and a third passivating region being provided between an emitter region and a backcontact region. Preferably, the first layer of the first conductivity type of the emitter regions or the second layer of the second conductivity type of the backcontact regions may cover at most 10% of the surface of a third passivating region.

In some embodiments, the backcontact regions may be disconnected one from each other.

In other embodiments, the backcontact regions may be all connected to each other.

In a preferred embodiment, each backcontact region is formed by a continuous surface having an area of at least of 0.09 mm².

Preferably, the backcontact region may comprise, from the inside to the outside of the solar cell, an intrinsic layer, the second layer of the second conductivity type, and the second contact layer allowing a carrier extraction or injection.

Said second contact layer may be selected from a transparent conductive oxide layer, a metallic layer, and a combination thereof.

In some embodiments, the front side of the solar cell may comprise a front passivation surface.

In some embodiments, the emitter regions may be disconnected one from each other.

In other embodiments, the emitter regions may be all connected one to each other.

In a preferred embodiment, each emitter region is formed by a continuous surface having an area of at least 0.09 mm².

Preferably, the emitter region may comprise, from the inside to the outside of the solar cell, an intrinsic layer, the first layer of the first conductivity type, and the first contact layer allowing a carrier extraction or injection.

Said first contact layer is selected from a transparent conductive oxide layer, a metallic layer, and a combination thereof.

Preferably, the first, second or third passivating layer may comprise at least an intrinsic layer.

In some embodiments, the intrinsic layers may be made of hydrogenated amorphous silicon.

Advantageously, the intrinsic layer of the third passivating layer is the same as the intrinsic layer of the emitter regions and of the backcontact regions.

In other embodiments, the first, second or third passivating layer may be a non-absorbing layer selected from a SiNx layer, a Al₂O₃ layer, a stack SiOx/SiNy, a layer comprising Si, O and N, and a combination thereof.

Preferably, the first, second or third optional additional layer is a protective layer.

Advantageously, the first layer of the first conductivity type or the second layer of the second conductivity type may comprise hydrogenated amorphous silicon which is able to contain a phase of silicon with up to 80% of Raman Si crystalline fraction.

The hydrogenated amorphous silicon may be alloyed with atoms selected from O, N, C, and Ge, the fraction of Si atoms remaining at 30% of the atoms in the layer, without counting the H atoms present.

### Brief description of the drawings

Figure 1 is a typical cross section of a front SHJ cell corresponding to the prior art;
Figure 2 is a typical cross section of a back contacted IBC-SHJ cell corresponding to the prior art;
Figures 3 and 4 are cross section of front SHJ cells of the invention;
Figures 5 and 6 are cross section of IBC-SHJ cells not part of the invention;
Figure 7 and 8 are schematic bottom views of the emitter and backcontact regions in a IBC-SHJ cell of the invention;
Figure 9 is a schematic perspective view of a front SHJ cell of the invention, corresponding to the cross section view of Figure 3; and
Figure 10 shows the fill factor obtained for several solar cells of the invention compared to standard devices.

### Detailed description

In the present description, everything which is described for a n-type wafer also applies to p-doped wafer and to intrinsic wafer, with the role of the n and p layers being reversed.

In the present description, the same references are used to design the same elements.

A solar cell according to the invention comprises a semiconductor wafer, an emitter formed by at least one emitter region which comprises at least a first layer of a first conductivity type and a first contact layer allowing a carrier extraction or injection, a backcontact comprising at least a second layer of a second conductivity type opposite of said first conductivity type and a second contact layer allowing a carrier extraction or injection. Electrical contacts are connected to said emitter regions and said backcontact respectively are designed to transport an electrical current out of the solar cell. According to the present invention, the area of the emitter covers between 0.5% to 15%, preferably between 1% and 10% and more preferably between 2% and 5% of the area of a side of the wafer on which the emitter regions are provided, the rest of the area of said side of the wafer being covered by first passivating regions comprising at least a first passivating layer and at least one first optional additional layer which makes that the first passivating layer does not allow a carrier extraction or injection and is not contacted electrically to the contacts, said first passivating regions being not fully covered by the first layer of the first conductivity type of the emitter regions.

If the solar cell comprises several emitter regions 20, corresponding to the most usual cases, the area of the emitter corresponds to the sum of the areas of each emitter region 20 which covers said side of the wafer.

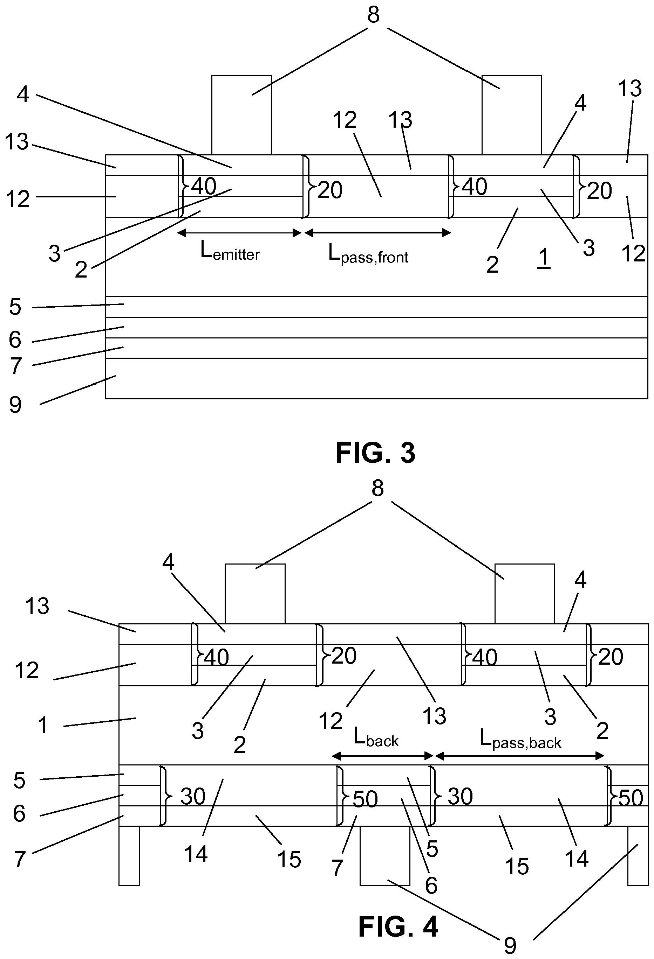

Figure 3 and 4 show two possible applications of the invention to the Front-SHJ case.

In the configuration of Figure 3, the cell comprises a n-type crystalline silicon wafer 1 and at the back, a classical backcontact comprising the i-layer 5 covered by the n-layer 6 covered by a back TCO layer 7 covered by a metal layer 9 for the back metallisation.

In the front side of the solar cell, the emitter regions 20 comprises, as defined above a stack i-layer 2/p-layer 3/a front TCO layer 4, from the inside to the outside of the solar cell. According to the invention said emitter regions 20 do not cover the full front surface of the wafer 1 but only a small fraction of it, typically 1 to 10% only. The metal fingers 8 contact the remaining emitter regions 20 but can either cover fully the front TCO layer 4 or only partially. When no emitter is present at the front, and more particularly no p-layer which could contribute to collecting the current, this part of the device is a first passivating region 40 called "the front passivating part" comprising the passivating layer 12. That means that a first passivating region 40 comprising said passivating layer 12 is provided between two emitter regions 20. The length of this part is called L_{pass,front}. Such passivating layer 12 could be an i-layer or an ip stack in the easiest configuration in such a case the p-layer has little lateral conductivity (> 10 kOhm square) and cannot contribute to collecting the photogenerated current. Typically no TCO with a significant lateral conductivity is contacting the passivating layer 12. A protective additional layer 13, which corresponds to a dielectric with optical properties useful for creating an antireflection effect, is typically present on top of the passivating layer 12. The function of layers 12 and 13 can also be merged.

In Figure 4, the same principle is also applied to the backside of the solar.

In the front side of the solar cell, the emitter regions 20 are the same as shown by Figure 3. In this embodiment, the backcontact of the solar cell comprises backcontact regions 30 which comprise, as defined above a stack i-layer 5/n-layer 6/a back TCO layer 7, from the inside to the outside of the solar cell. According to the invention said backcontact regions 30 do not cover the full back surface of the wafer but only a small fraction of it, typically 1 to 10% only. Metal fingers 9 contact the remaining backcontact regions but can either cover fully the back TCO layer 7 or only partially. When no backcontact is present at the back side, and more particularly no n-layer which could contribute to collecting the current, this part of the device is the second passivating region 50 called "the back passivating part" comprising the passivating layer 14. That means that a second passivating region 50 comprising said passivating layer 14 is provided between two backcontact regions 30. The length of this part is called L_{pass,back}. Such passivating layer 14 could be a i-layer or a i-n stack in the easiest configuration in such a case the n-layer has little lateral conductivity (> 10 kOhm square) and cannot contribute to collecting the photogenerated current. Typically no TCO with a significant lateral conductivity is contacting the passivating layer 14. An additional layer 15, which corresponds to a dielectric with optical properties useful for creating an antireflection effect, is typically present on top of the passivating layer 14. Layer 15 could also be fully covered by the metal contact 9 or by a layer consisting of TCO and Metal.

According to the invention, the area of the backcontact covers between 0.5% to 15%, preferably between 1% and 10% and more preferably between 2% and 5% of the area of the backside of the wafer 1, the rest of the area of the backside of the wafer 1 being covered by the second passivating regions 50 comprising the passivating layer 14.

If the solar cell comprises several backcontact regions 30, corresponding to the most usual cases, the area of the backcontact corresponds to the sum of the areas of each backcontact region 30 which covers said backside of the wafer.

Such embodiment allows to enhance the desired effect, the current having to flow through the back-contact area which is also smaller than the backside surface.

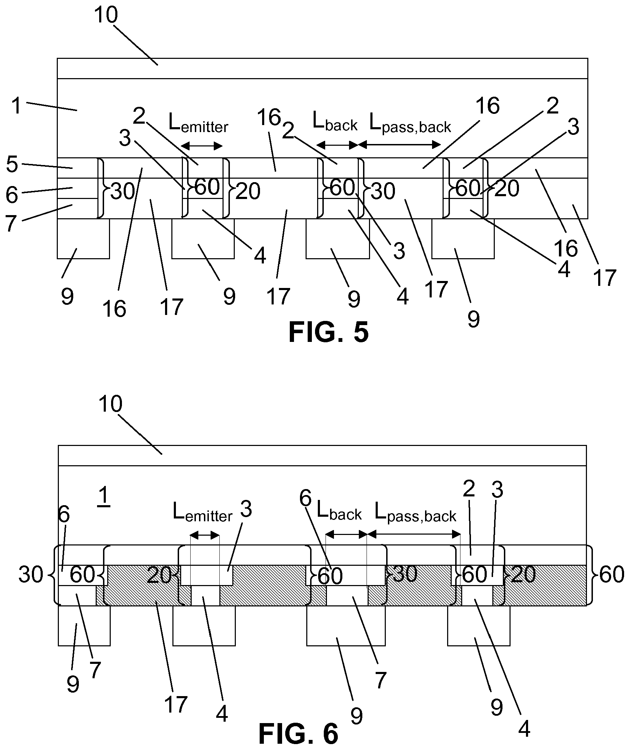

Figures 5 and 6 shows two possible applications not part of the invention to the IBC-SHJ case.

In these embodiments not part of the invention, the emitter regions are provided on the back side of the solar cell, and the areas of the emitter and of the backcontact cover between 0.5% to 15%, preferably between 1% and 10% and more preferably between 2% and 5% of the area of the back side of the wafer, the rest of the area of the back side of the wafer being covered by third passivating regions which comprise a passivating layer.

The solar cell of Figure 5 comprises a n-type wafer 1, at its front side, a front passivation and antireflection surface 10 and at its back side, emitter regions 20 and backcontact regions 30, each being separated from each other by a third passivating region 60 comprising a passivating layer 16. A protective additional layer 17, which corresponds to an insulating layer is present on top of the passivating layer 16 and is chosen also to give good optical reflectance.

The solar cell comprises also metal fingers 9.

The areas of the emitter and of the backcontact (that means the sum of the areas of the emitter regions and the sum of the areas of the backcontact regions) cover between 0.5% to 15%, preferably between 1% and 10% and more preferably between 2% and 5% of the area of the backside of the wafer, the rest of the area of the back side of the wafer being covered by said third passivating regions 60 comprising the passivating layer 16.

As defined above, the emitter region 20 comprises a stack i-layer 2/p-layer 3/a TCO layer 4, and the backcontact region 30 comprises a stack i-layer 5/n-layer 6/a TCO layer 7, from the inside to the outside of the solar cell.

The solar cell of Figure 6 corresponds to an embodiment of IBC-SHJ similar to the embodiment of Figure 5, but in which the intrinsic layer of the passivating layers 16 of the third passivating regions 60 is the same as the instrinsic layers 2 and 5 of the emitter regions 20 and of the backcontact regions 30 respectively.

In this embodiment, the TCO layers 4 or 7 which defines the length Lₑₘᵢₜₜₑᵣ and L_{back} does not need to cover the full i-p stack or the full i-n stack, allowing for easier processing.

All these configurations have remarkable advantages, especially when wafers with a good lifetime are used (typically 1 millisecond and more for n-type wafer).

Indeed, as the heterojunction works at high injection level (because of the high voltage at the operating point of the cell, the point where the voltage x current product of the device under illumination is the largest), the passivating layer 12, 14, 16 present around the wafer ensures a very good electronic passivation and even if a wafer with high resistivity is used, a high conductivity is ensured because of the high number of carriers present. This allows a transport of current both with little resistive loss and with little recombination, because the diffusion length can be as long as a few mm if a wafer with sufficient lifetime is used. The carriers are then extracted through a limited area, but the current is generated over a large area. This creates at the working point of the solar cell conditions of concentration. This condition leads to a higher extracted power (and consequently fill factor of the solar cell).

For instance in the geometry of Figure 3, if the ratio of the length of the emitter region Lₑₘᵢₜₜₑᵣ to the passivated area length L_{pass,front}, a concentration factor of Lₑₘᵢₜₜₑᵣ / L_{pass,front} is achieved which leads to a higher efficiency. Interestingly mostly the fill factor is increased not the Voc which is limited by the general passivation quality and by Auger recombination.

Advantageously, for a typical cell geometry, in a cross section through the side and through the contact grid, the typical pitch (Lₑₘᵢₜₜₑᵣ+L_{pass,front}) or L_{back}+L_{back, pass} for the front SHJ cell, or Lₑₘᵢₜₜₑᵣ+L_{back+}L_{back, pass} for the IBC-SHJ cell is in the range of 100 microns to 1.5 mm, preferably between 300 microns and 1.0 mm.

For the sake of clarity, it is assumed that the described lengths are proportional to the covered area (assuming in a 2D geometry that the figure extends in the third dimension).

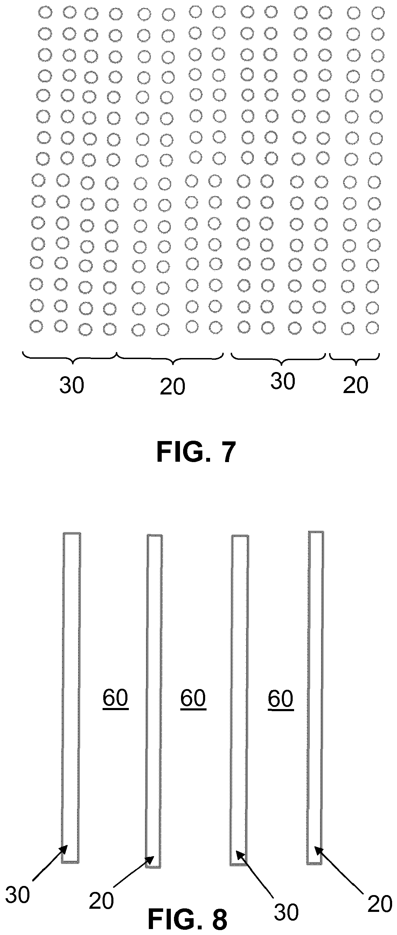

In some embodiments each emitter region 20 is formed by discontinuous points and each backcontact region 30 is formed by discontinuous points, each region having typically an area comprised between 20x20 µm² and 100x100 µm². Such a configuration is schematically shown in Figure 7 for a IBC-SHJ cell.

In other preferred embodiment, said emitter regions 20 and said backcontact regions 30 are formed respectively by at least one substantially continuous surface. Such a configuration is schematically shown in Figure 8 for a IBC-SHJ cell. Preferably, the form of said continuous surface is substantially rectangular when the cell is viewed from the top or the bottom of the cell, as shown by Figure 8.

In such case, said emitter region or backcontact region in contact with silicon has at least an area of 0.09 mm², with typical dimensions of 30 µm x 3 mm at least. Such dimensions are those of the continuous surfaces formed on the cell and viewed from the top or the bottom of the cell, as shown by Figure 8.

In some embodiments, each emitter region 20 may be disconnected from each other and each backcontact region 30 may be disconnected from each other.

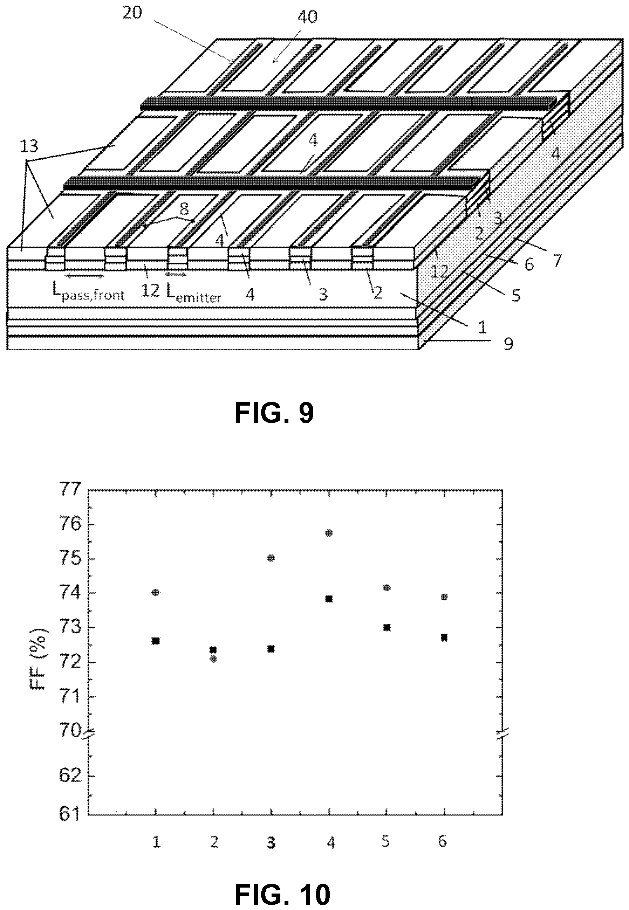

In other preferred embodiments, all emitter regions 20 of the solar cell are connected to each other or all backcontact regions 30 are connected to each other. Such an embodiment is shown by Figure 9 for a front SHJ cell, in which the emitter regions 20 are continuous surfaces and form a network on all the solar cell.

Another advantage of the configuration is that, as a large fraction of the solar cells been not covered by the emitter region, it is possible to optimize separately the properties of layers 10, 12 and 13, or 14 and 15 or 16, 17 and 20 for improved passivation properties and for a reduction of the optical parasitic absorption. For instance in these parts, the TCO layer may be replaced by a SiNx layer and the p-layer thickness can be reduced or the p-layer can be totally suppressed if an i-p stacks was constituting the layer 12 or 16. Conversely, as the area of the emitter becomes similar to the area of the contact fingers, it becomes even possible to use TCO with adapted properties (e.g. with higher doping), or to use much thinner TCO if a metal is directly on top, thereby avoiding losses. It is even to suppress completely the TCO, replacing it by a metal or metal alloy that makes directly a contact to the p-type amorphous layer.

When applied to IBC-SHJ scheme, as shown by Figure 5 and 6, the concentration effect is also similar. The invention works best for a ratio of Lₑₘᵢₜₜₑᵣ/(Lₑₘᵢₜₜₑᵣ+L_{back}+L_{pass,back}) of 1 to 20% An advantage of this solution is, beyond the concentration effect, is that there is more tolerance to align the emitter and/or the TCO and metal contact, as illustrated in Figure 6.

In the present description, all represented i, n and p layers are based on hydrogenated amorphous silicon and can also contain several percents of O, N, C or Ge, the fraction of silicon atoms remaining at 30% of the atoms in the layer, without counting the H atoms present. Preferably the amount of O, N, C or Ge is equal to 0-20%, more preferably equal to 0-10% and more preferably equal to 0-5%.

The p and n layers can contain a phase of silicon, up to 80% Raman silicon crystalline fraction.

The emitter region consists typically in a-Si layer having a thickness comprised between 4 nm and 10 nm, a p-layer having a thickness comprised between 3 nm and 15 nm and a TCO contact layer having a thickness comprised between 10 nm and 80 nm, or between 10 nm and 300 nm if the emitter is located at the back.

The backcontact region consists typically in a-Si layer having a thickness comprised between 4 nm and 10 nm, a n-layer having a thickness comprised between 3 nm and 15 nm, and a TCO layer having a thickness comprised between 10 nm and 300 nm.

For simplicity of manufacturing, layer 12 (front passivating layer), can be an i-layer or an i-p stack (with possibly a thinner p layer) or even an i-n stack. The thickness of the front passivating layer is higher than 5 nm. It could also be a non-absorbing layer such SiNₓ or Al₂O₃ or a stack SiOₓ/SiN_{y} or a layer comprising in general Si, O and N, or a combination thereof.

For simplicity of manufacturing, layer 14 (back passivating layer), can be an i-layer or an i-n stack (with possibly a thinner n layer) or even an i-p stack. The thickness of the back passivating layer is higher than 5 nm. It could also be a non-absorbing layer such SiNₓ or Al₂O₃ or a stack SiOₓ/SiN_{y} or a layer comprising in general Si, O and N, or a combination thereof. In such a case it might possible to omit layer 17.

The optical and electrically insulating layer 13, 15 or 17 can be a thin stack of hydrogenated amorphous silicon layers covered by a SiNₓ layer or SiNOₓ layer stack or by a weakly absorbing layer.

The front passivation and antireflection surface 10 is known from one skilled in the art and may be for example a very thin intrinsic hydrogenated amorphous silicon layer (3-10 nm), possibly covered by 1-5 nm of doped amorphous Si covered by a SiNₓ layer or SiNyOₓ layer or a stack of layer comprising Si, O and N, or a weakly doped TCO layer (carrier concentration <10²⁰ cm⁻³). The thickness of these layers is selected to obtain a antireflection effect. Typically one can use a SiNₓ layer with a refractive index comprised between 1.8 and 2 and a thickness of 70 nm.

The layers 10 and 13, 15 or 17 that play a role of optical layer, of electrically insulating layer to prevent injection or extraction of carrier and that can possibly be used as masking layer for plating process can be tuned with grading refractive index between, as they do not need to be electrically active.

For devices where a large fraction of the surface is active for carrier extraction, the use of TCO's is requested with sufficient in-plane conductivity (20 to 200 Ohm sq) for the front and providing antireflection at the front and index matching at the back, but it is possible to suppress the TCO layer and replace it with a direct metallic contact. This requires then that the emitter region has the same size as the grid finger in the Front-SHJ.

The TCO layer is known from one skilled in the art and may be typically made of ITO (Indium Tin Oxides) doped with tin (In₂O₃:Sn) or other metal dopants or with hydrogen In₂O₃:H, or a stack of these layers, with carrier concentration comprised between 10¹⁹ cm⁻³ and 2x10²¹ cm⁻³. The TCO layer may be also made of doped ZnO or other TCO containing In, Zn and Sn. The thickness of the TCO layer is comprised between 10 nm and 300 nm, typically between 70 nm and 90 nm when present at the front and between 80 nm to 300 nm when present at the backside.

The wafer used in the solar cell has typically a size comprised between 2x2 cm² and 22x22 cm².

The front surface of the wafer has a texture to reduce the reflection and trap the light inside the wafer, as known for one skilled in the art.

### Example:

The following example illustrates the present invention without however limiting the scope.

For this experiment, first a regular Front-SHJ device of 20x20 mm² was prepared with a 80 nm thick ITO layer, and with finger spacing (Lₑₘᵢₜₜₑᵣ+L_{pass, front}) after processing of around 1 mm was prepared. Then the contact fingers and part of the ITO were protected by a photoresist. The photoresist was etched away and then the ITO was simply etched away where the photoresist was opened. A dielectric was then deposited where the ITO has been removed to ensure suitable antireflection conditions. Various coverage ratio of the ITO were tested. Figure 9 shows the fill factor FF (FF is the ratio between the maximum power that can be extracted divided by the product of short-circuit current x the open-circuit voltage) obtained for several Front-SHJ cells of the invention and comparative standard devices The rounded dots correspond to a solar cell of the invention, after the removal of the front TCO, and the square dots correspond to a comparative standard device before the removal of the front TCO. Example 3 is a reference sample, Example 1 corresponds to a low emitter coverage fraction (5%), Examples 3 and 4 correspond to an ultra-low emitter coverage fraction (2%), and Examples 5 and 6 correspond to a medium emitter coverage fraction (20%).

Figure 10 shows for a Front-SHJ cell that the invention allows a fill factor increase of several percents for several types of samples, when compared to standard devices. Best results are obtained for a coverage of the emitter comprised between 2% and 10% of the area of the wafer. In this case the emitter was only in one part formed by all emitter regions which are connected to each other as shown by Figure 9 i.e. with an area of between 2% and 10% of 20x20 mm².

The solar cells of the invention have a potential to be almost perfect photovoltaic device. Even though no optical lens is used, the cell structure can create a strong effective concentration that can push the efficiency of crystalline solar cell well beyond the current world record of 25%, allowing in principle to come close to 29-30%, closer to the theoretical limit for crystalline silicon solar cells.

## Claims

1. Solar cell comprising:
- a semiconductor wafer (1),
- an emitter provided on a front side of the semiconductor wafer and formed by at least one emitter region (20) which comprises at least a first layer of a first conductivity type (3) and a first contact layer (4) allowing a carrier extraction or injection,
- a backcontact comprising at least a second layer of a second conductivity type (6) opposite of said first conductivity type and a second contact layer (7) allowing a carrier extraction or injection,
- electrical contacts (8, 9) which are connected to said emitter regions (20) and said backcontact respectively and designed to transport an electrical current out of the solar cell,
**characterized in that** the area of the emitter covers between 0.5% to 15%, preferably between 1% and 10% and more preferably between 2% and 5% of the area of a side of the wafer (1) on which the emitter regions (20) are provided, the rest of the area of said side of the wafer (1) being covered by first passivating regions (40) which comprise at least a first passivating layer (12, 16), said first passivating regions (40) being deprived from the first layer of the first conductivity type (3) of the emitter regions (20).

2. Solar cell according to claim 1, **characterized in that** the backcontact is formed by at least one backcontact region (30) which comprises at least a second layer of the second conductivity type (6) and a second contact layer (7) allowing a carrier extraction or injection, and **in that** the area of the backcontact covers between 0.5% to 15%, preferably between 1% and 10% and more preferably between 2% and 5% of the area of the backside of the wafer (1), the rest of the area of the backside of the wafer being covered by second passivating regions (50) which comprise at least a second passivating layer (14), said second passivating regions (50) being deprived from the second layer of the second conductivity type (6) of the backcontact regions (30).

3. Solar cell according to claim 2, **characterized in that** the backcontact regions (30) are disconnected one from each other.

4. Solar cell according to claim 2, **characterized in that** the backcontact regions (30) are all connected one to each other.

5. Solar cell according to anyone of claims 2 to 4, **characterized in that** each backcontact region (30) is formed by a continuous surface having an area of at least 0.09 mm².

6. Solar cell according to anyone of the claims 2 to 5, **characterized in that** the backcontact region (30) comprises, from the inside to the outside of the solar cell, an intrinsic layer (5), the second layer of the second conductivity type (6), and the second contact layer (7) allowing a carrier extraction or injection.

7. Solar cell according to claim 6, **characterized in that** said second contact layer(7) is selected from a transparent conductive oxide layer, a metallic layer, and a combination thereof.

8. Solar cell according to anyone of claims 2 7, **characterized in that** its front side comprises a front passivation surface (10).

9. Solar cell according to anyone of the preceding claims, **characterized in that** the emitter regions (20) are disconnected one from each other.

10. Solar cell according to anyone of claims 1 to 8, **characterized in that** the emitter regions (20) are all connected one to each other.

11. Solar cell according to anyone of the preceding claims, **characterized in that** each emitter region (20) is formed by a continuous surface having an area of at least 0.09 mm².

12. Solar cell according to anyone of the preceding claims, **characterized in that** the emitter region (20) comprises, from the inside to the outside of the solar cell, an intrinsic layer (2), the first layer of the first conductivity type (3), and the first contact layer (4) allowing a carrier extraction or injection.

13. Solar cell according to claim 12, **characterized in that** said first contact layer (4) is selected from a transparent conductive oxide layer, a metallic layer, and a combination thereof.

14. Solar cell according to anyone of the preceding claims, **characterized in that** the first or second passivating layer (12, 14) comprises at least an
intrinsic layer.

15. Solar cell according to claims 6, 12 and 14, **characterized in that** the intrinsic
layers are made of hydrogenated amorphous silicon.

16. Solar cell according to anyone of claims 1 to 13, **characterized in that** the first or second passivating layer (12, 14) is a non-absorbing layer selected from a SiNx layer, a Al₂O₃ layer, a stack SiOx/SiNy, a layer comprising Si, O and N, and a combination thereof.

17. Solar cell according to anyone of the preceding claims, **characterized in that** the first layer of the first conductivity type (3) or the second layer of the second conductivity type (6) comprises hydrogenated amorphous silicon which is able to contain a phase of silicon with up to 80% of Raman Si crystalline fraction.

18. solar cell according to anyone of the claims 15 and 17, **characterized in that** said hydrogenated amorphous silicon is alloyed with atoms selected from O, N, C, and Ge, the fraction of Si atoms remaining at 30% of the atoms in the layer, without counting the H atoms present.

## Patentansprüche

1. Solarzelle, die umfasst:
- einen Halbleiterwafer (1),
- einen Emitter, der auf einer Vorderseite des Halbleiterwafers bereitgestellt ist und durch zumindest eine Emitterregion (20) gebildet ist, umfassend zumindest eine erste Schicht eines ersten Leitfähigkeitstyps (3) und eine erste Kontaktschicht (4), die eine Trägerextraktion oder -injektion ermöglicht,
- einen Rückkontakt, der zumindest eine zweite Schicht eines zweiten Leitfähigkeitstyps (6), der dem ersten Leitfähigkeitstyp entgegengesetzt ist, und eine zweite Kontaktschicht (7), die eine Trägerextraktion oder -injektion ermöglicht, umfasst
- elektrische Kontakte (8, 9), die mit den Emitterregionen (20) bzw. dem Rückkontakt verbunden und so ausgelegt sind, dass sie einen elektrischen Strom aus der Solarzelle heraustransportieren,
**dadurch gekennzeichnet, dass** die Fläche des Emitters zwischen 0,5 % und 15 %, vorzugsweise zwischen 1 % und 10 % und mehr bevorzugt zwischen 2 % und 5 % der Fläche einer Seite des Wafers (1) abdeckt, auf der die Emitterregionen (20) bereitgestellt sind, wobei der Rest der Fläche der Seite des Wafers (1) durch erste Passivierungsregionen (40) abgedeckt ist, die zumindest eine erste Passivierungsschicht (12, 16) umfassen, wobei die erste Schicht des ersten Leitfähigkeitstyps (3) der Emitterregionen (20) den ersten Passivierungsregionen (40) entzogen ist.

2. Solarzelle nach Anspruch 1, **dadurch gekennzeichnet, dass** der Rückkontakt durch zumindest eine Rückkontaktregion (30) gebildet ist, die zumindest eine zweite Schicht des zweiten Leitfähigkeitstyps (6) und eine zweite Kontaktschicht (7) umfasst, die eine Trägerextraktion oder -injektion ermöglicht, und dass die Fläche Rückkontakts zwischen 0,5 % und 15 %, vorzugsweise zwischen 1 % und 10 % und mehr bevorzugt zwischen 2 % und 5 % der Fläche der Fläche der Rückseite des Wafers (1) abdeckt, wobei der Rest der Fläche der Rückseite des Wafers (1) durch zweite Passivierungsregionen (50) abgedeckt ist, die zumindest eine zweite Passivierungsschicht (14) umfassen, wobei die zweite Schicht des zweiten Leitfähigkeitstyps (6) der Rückkontaktregionen (30) den zweiten Passivierungsregionen (50) entzogen ist.

3. Solarzelle nach Anspruch 2, **dadurch gekennzeichnet, dass** die Rückkontaktregionen (30) nicht miteinander verbunden sind.

4. Solarzelle nach Anspruch 2, **dadurch gekennzeichnet, dass** die Rückkontaktregionen (30) allesamt miteinander verbunden sind.

5. Solarzelle nach einem der Ansprüche 2 bis 4, **dadurch gekennzeichnet, dass** jede Rückkontaktregion (30) durch eine kontinuierliche Oberfläche mit einer Fläche von zumindest 0,09 mm² gebildet ist.

6. Solarzelle nach einem der Ansprüche 2 bis 5, **dadurch gekennzeichnet, dass** die Rückkontaktregion (30) von Inneren der Solarzelle nach außen eine intrinsische Schicht (5), die zweite Schicht des zweiten Leitfähigkeitstyps (6) und die zweite Kontaktschicht (7) umfasst, die eine Trägerextraktion oder -injektion ermöglicht.

7. Solarzelle nach Anspruch 6, **dadurch gekennzeichnet, dass** die zweite Kontaktschicht (7) aus einer transparenten leitfähigen Oxidschicht, einer Metallschicht und einer Kombination davon ausgewählt ist.

8. Solarzelle nach einem der Ansprüche 2 bis 7, **dadurch gekennzeichnet, dass** ihre Vorderseite eine vordere Passivierungsoberfläche (10) umfasst.

9. Solarzelle nach einem der vorstehenden Ansprüche, **dadurch gekennzeichnet, dass** die Emitterregionen (20) nicht miteinander verbunden sind.

10. Solarzelle nach einem der Ansprüche 1 bis 8, **dadurch gekennzeichnet, dass** die Emitterregionen (20) allesamt miteinander verbunden sind.

11. Solarzelle nach einem der vorstehenden Ansprüche, **dadurch gekennzeichnet, dass** jede Emitterregion (20) durch eine kontinuierliche Oberfläche mit einer Fläche von zumindest 0,09 mm² gebildet ist.

12. Solarzelle nach einem der vorstehenden Ansprüche, **dadurch gekennzeichnet, dass** die Emitterregion (20) von Inneren der Solarzelle nach außen eine intrinsische Schicht (2), die erste Schicht des ersten Leitfähigkeitstyps (3) und die erste Kontaktschicht (4) umfasst, die eine Trägerextraktion oder -injektion ermöglicht.

13. Solarzelle nach Anspruch 12, **dadurch gekennzeichnet, dass** die erste Kontaktschicht (4) aus einer transparenten leitfähigen Oxidschicht, einer Metallschicht und einer Kombination davon ausgewählt ist.

14. Solarzelle nach einem der vorstehenden Ansprüche, **dadurch gekennzeichnet, dass** die erste oder die zweite Passivierungsschicht (12, 14) zumindest eine intrinsische Schicht umfasst.

15. Solarzelle nach den Ansprüchen 6, 12 und 14, **dadurch gekennzeichnet, dass** die intrinsischen Schichten aus hydriertem amorphem Silicium hergestellt sind.

16. Solarzelle nach einem der Ansprüche 1 bis 13, **dadurch gekennzeichnet, dass** die erste oder zweite Passivierungsschicht (12, 14) eine nichtabsorbierende Schicht ist, die aus einer SiNx-Schicht, einer Al₂O₃-Schicht, einem SiOx/SiNy-Stapel, einer Schicht, die Si, O und N umfasst, und einer Kombination davon ausgewählt ist.

17. Solarzelle nach einem der vorstehenden Ansprüche, **dadurch gekennzeichnet, dass** die erste Schicht des ersten Leitfähigkeitstyps (3) oder die zweite Schicht des zweiten Leitfähigkeitstyps (6) hydriertes amorphes Silicium umfasst, das in der Lage ist, eine Siliciumphase mit einer kristallinen Raman-Si-Fraktion von bis zu 80 % zu enthalten.

18. Solarzelle nach einem der Ansprüche 15 und 17, **dadurch gekennzeichnet, dass** das hydrierte amorphe Silicium mit Atomen legiert ist, die aus O, N, C und Ge ausgewählt sind, wobei die Fraktion von Si-Atomen bei 30 % der Atome in der Schicht bleibt, wobei die vorhandenen H-Atome nicht gezählt werden.

## Revendications

1. Pile solaire comprenant :
- une tranche semi-conductrice (1),
- un émetteur fourni sur le côté avant de la tranche semi-conductrice et formé d' au moins une région émettrice (20) qui comprend au moins une première couche d' un premier type de conductivité (3) et une première couche de contact (4) permettant l'extraction ou l'injection d' un support,
- un contact arrière comprenant au moins une seconde couche d' un second type de conductivité (6) opposé audit premier type de conductivité et une seconde couche de contact (7) permettant l'extraction ou l'injection d' un support,
- des contacts électriques (8, 9) qui sont connectés auxdites régions émettrices (20) et audit contact arrière respectivement et conçus pour transporter un courant électrique hors de la pile solaire,
**caractérisée en ce que** l'aire de l'émetteur recouvre entre 0,5 % et 15 %, de préférence entre 1 % et 10 % et de préférence encore entre 2 % et 5 % de l'aire d' un côté de la tranche (1) sur lequel sont fournies les régions émettrices (20), le reste de l'aire dudit côté de la tranche (1) étant recouvert de premières régions de passivation (40) qui comprennent au moins une première couche de passivation (12, 16), lesdites premières régions de passivation (40) étant dépourvues de la première couche du premier type de conductivité (3) des régions émettrices (20).

2. Pile solaire selon la revendication 1, **caractérisée en ce que** le contact arrière est formé d' au moins une région de contact arrière (30) qui comprend au moins une seconde couche du second type de conductivité (6) et une seconde couche de contact (7) permettant l'extraction ou l'injection d' un support, et **en ce que** l'aire du contact arrière recouvre entre 0,5 % et 15 %, de préférence entre 1 % et 10 % et de préférence encore entre 2 % et 5 % de l'aire du côté arrière de la tranche (1), le reste de l'aire du côté arrière de la tranche étant recouvert de secondes régions de passivation (50) qui comprennent au moins une seconde couche de passivation (14), lesdites secondes régions de passivation (50) étant dépourvues de la seconde couche du second type de conductivité (6) des régions de contact arrière (30).

3. Pile solaire selon la revendication 2, **caractérisée en ce que** les régions de contact arrière (30) sont déconnectées les unes des autres.

4. Pile solaire selon la revendication 2, **caractérisée en ce que** les régions de contact arrière (30) sont toutes connectées les unes aux autres.

5. Pile solaire selon l'une quelconque des revendications 2 à 4, **caractérisée en ce que** chaque région de contact arrière (30) est formée d' une surface continue ayant une aire d' au moins 0,09 mm².

6. Pile solaire selon l'une quelconque des revendications 2 à 5, **caractérisée en ce que** la région de contact arrière (30) comprend, de l'intérieur vers l'extérieur de la pile solaire, une couche intrinsèque (5), la seconde couche du second type de conductivité (6) et la seconde couche de contact (7) permettant l'extraction ou l'injection d' un support.

7. Pile solaire selon la revendication 6, **caractérisée en ce que** ladite seconde couche de contact (7) est choisie parmi une couche d' un oxyde conducteur transparent, une couche métallique et leur mélange.

8. Pile solaire selon l'une quelconque des revendications 2 à 7, **caractérisée en ce que** son côté avant comprend une surface de passivation avant (10).

9. Pile solaire selon l'une quelconque des revendications précédentes, **caractérisée en ce que** les régions émettrices (20) sont déconnectées les unes des autres.

10. Pile solaire selon l'une quelconque des revendications 1 à 8, **caractérisée en ce que** les régions émettrices (20) sont toutes connectées les unes aux autres.

11. Pile solaire selon l'une quelconque des revendications précédentes, **caractérisée en ce que** chaque région émettrice (20) est formée d' une surface continue ayant une aire d' au moins 0,09 mm².

12. Pile solaire selon l'une quelconque des revendications précédentes, **caractérisée en ce que** la région émettrice (20) comprend, de l'intérieur vers l'extérieur de la pile solaire, une couche intrinsèque (2), la première couche du premier type de conductivité (3) et la première couche de contact (4) permettant l'extraction ou l'injection d' un support.

13. Pile solaire selon la revendication 12, **caractérisée en ce que** ladite première couche de contact (4) est choisie parmi une couche d' un oxyde conducteur transparent, une couche métallique et leur mélange.

14. Pile solaire selon l'une quelconque des revendications précédentes, **caractérisée en ce que** la première ou la seconde couche de passivation (12, 14) comprend au moins une couche intrinsèque.

15. Pile solaire selon les revendications 6, 12 et 14, **caractérisée en ce que** les couches intrinsèques sont constituées d' un silicium amorphe hydrogéné.

16. Pile solaire selon l'une quelconque des revendications 1 à 13, **caractérisée en ce que** la première ou la seconde couche de passivation (12, 14) est une couche non absorbante choisie parmi une couche de SiNx, une couche d' Al₂O₃, un empilement SiOx/SiNy, une couche comprenant Si, O et N, et leur mélange.

17. Pile solaire selon l'une quelconque des revendications précédentes, **caractérisée en ce que** la première couche du premier type de conductivité (3) ou la seconde couche du second type de conductivité (6) comprend un silicium amorphe hydrogéné qui peut contenir une phase de silicium comportant jusqu' à 80 % de fraction cristalline Si de Raman.

18. Pile solaire selon l'une quelconque des revendications 15 et 17, **caractérisée en ce que** ledit silicium amorphe hydrogéné est allié à des atomes choisis parmi O, N, C et Ge, la fraction d' atomes Si restant à 30 % des atomes de la couche, sans compter les atomes H présents.
